# FASCICULE DE BREVET EUROPEEN

(11) **EP 0 367 650 B1**
(45) Date de publication et mention de la délivrance du brevet: **09.06.1993**
(21) Numéro de dépôt: 89402865.3
(22) Date de dépôt: 17.10.1989
(51) Int. Cl.: H04N 3/15

(54) **Dispositif photosensible du type à amplification du signal au niveau des points photosensibles**
Photoempfindliche Vorrichtung mit Signalverstärkung im Bereich der photoempfindlichen Punkte
Photosensitive device with signal amplification at the photosensitive points

(30) Priorité: 25.10.1988 FR 8813913
(43) Date de publication de la demande: 09.05.1990
(73) Titulaire: THOMSON-CSF, 75008 Paris (FR)
(72) Inventeur: Berger, Jean-Luc, F-92402 Courbevoie Cédex (FR)
(74) Mandataire: Guérin, Michel

(56) Documents cités:
- EP-A- 0 046 396
- EP-A- 0 128 828
- FR-A- 2 605 166
- PATENT ABSTRACTS OF JAPAN, vol. 7, no. 162 (E-187)[1307], 15 juillet 1983; & JP-A-58 68 966

## Description

L'invention concerne un dispositif photosensible du type à l'état solide dans lequel est réalisée une amplification de signal au niveau des points photosensibles. L'invention concerne particulièrement un agencement nouveau des points photosensibles qui permet à la fois d'augmenter les qualités de fonctionnement de ces points photosensibles, et d'élargir les domaines dans lesquels ils peuvent être utilisés.

Il est courant d'utiliser des cellules photosensibles dans des dispositifs photosensibles à l'état solide où ces cellules photosensibles sont disposées de sorte à constituer une barrette ou détecteur linéaire, ou bien sont disposées selon un arrangement matriciel et constituent une matrice photosensible. Dans le cas d'une matrice photosensible, celle-ci comporte un réseau de conducteurs en ligne et un réseau de conducteurs en colonne. A chaque croisement d'un conducteur ligne et d'un conducteur colonne est disposé un montage photosensible ou cellule photosensible, appelé point photosensible dans la suite de la description ; les points photosensibles sont ainsi organisés également en ligne et en colonne. Selon une configuration classique, chaque point photosensible est connecté entre un conducteur ligne et un conducteur colonne.

Chaque point photosensible comporte au moins un élément photosensible tel que par exemple photodiode, phototransistor, sensible aux photons lumineux visibles ou proches du visible. Les photons lumineux sont convertis en charge électrique qui est accumulée dans une capacité électrique ; cette dernière forme une capacité de stockage qui peut être constituée soit par la capacité de l'élément photosensible lui-même, soit par une capacité annexe associée. Un dispositif de lecture permet d'interroger l'état électrique de la capacité de stockage, et de convoyer la charge électrique qui constitue le signal vers un amplificateur de signal.

Dans la configuration la plus classique, un point photosensible est constitué par un élément photosensible, une photodiode par exemple, monté en série avec un transistor du type MOS par exemple qui remplit uniquement une fonction d'interrupteur.

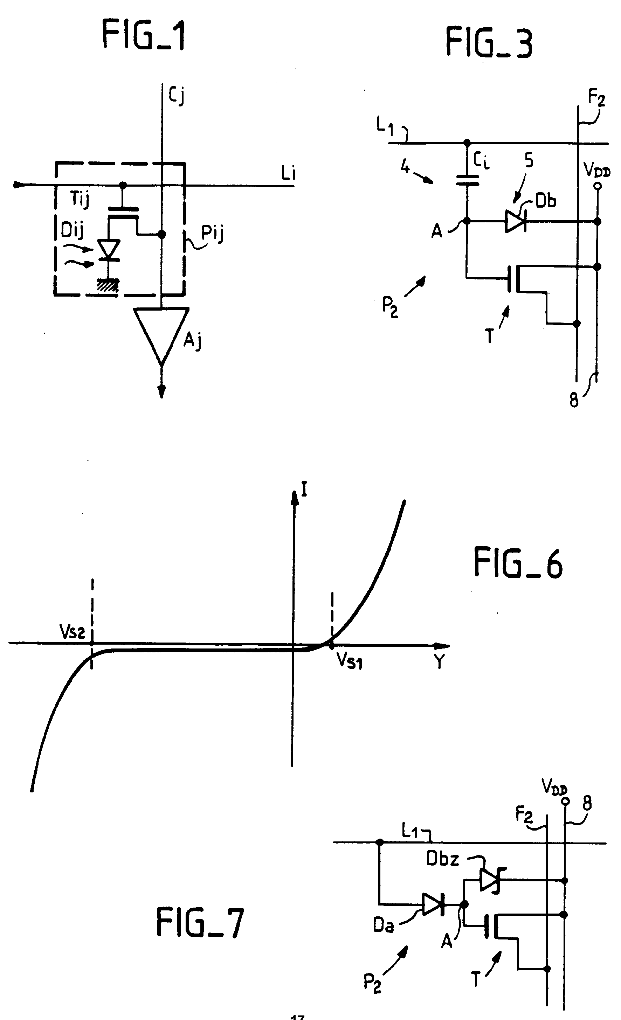

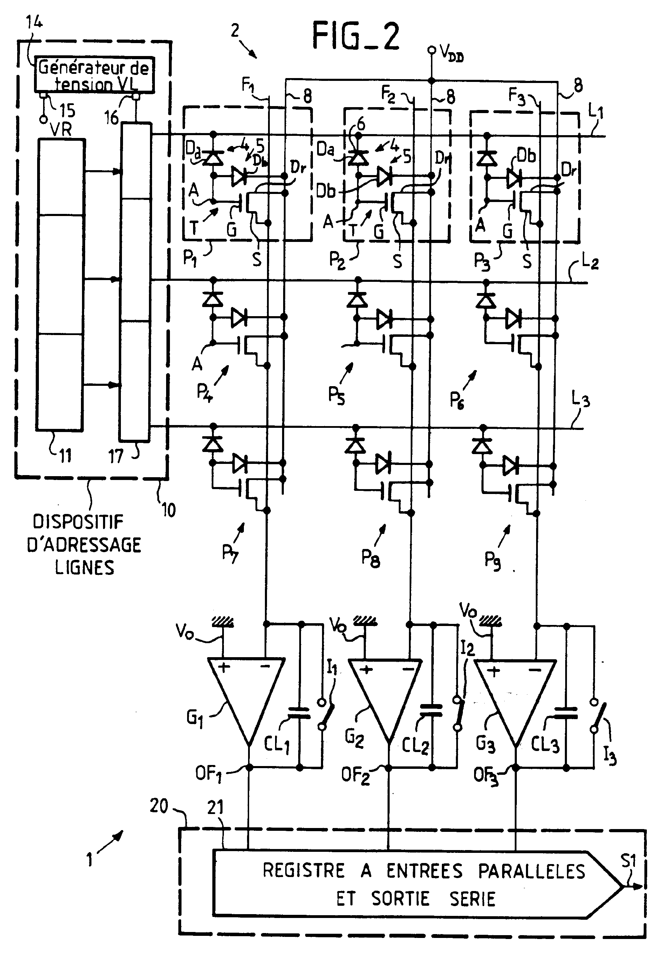

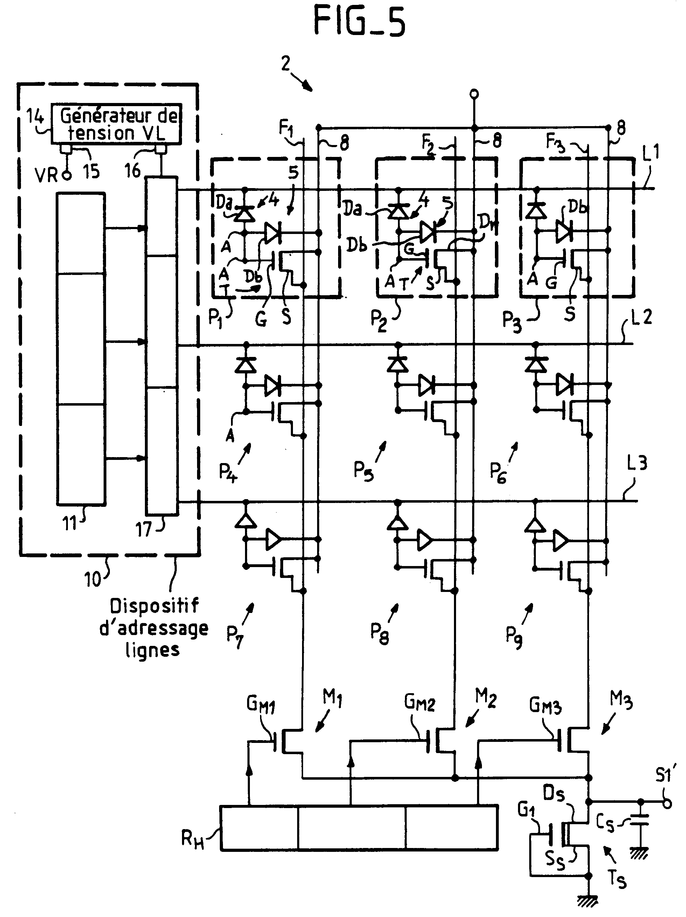

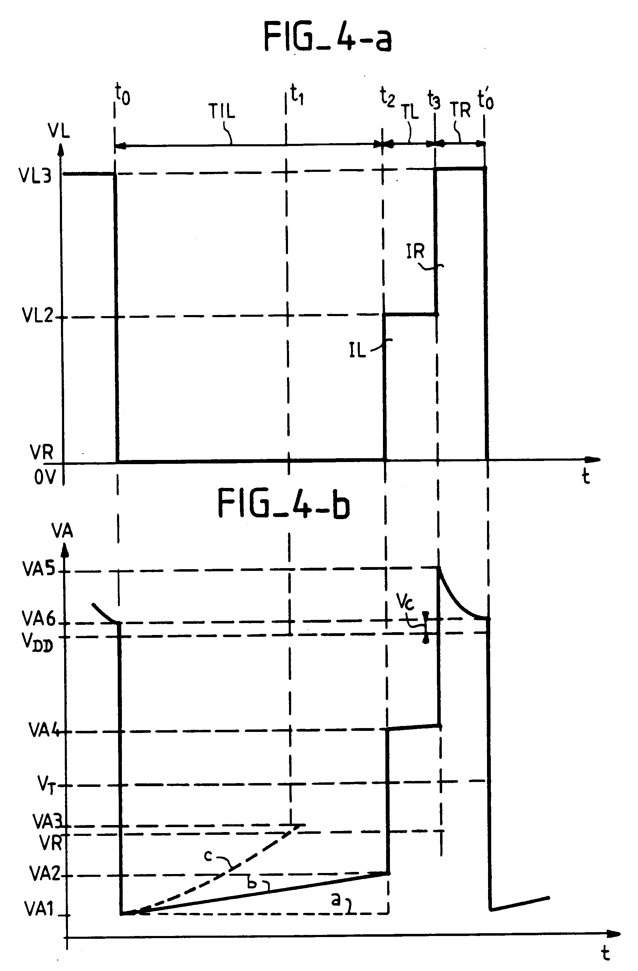

A la figure 1, on a représenté le schéma d'un point d'une matrice de points photosensibles de la technique antérieure ; cette matrice comporte un certain nombre de lignes et de colonnes et chaque point photosensible Pij est localisé au carrefour d'une ligne Li de rang i et d'une colonne Cj de rang j.

La ligne Li est matérialisée par un conducteur ligne orientée horizontalement, et la colonne Cj est matérialisée par un conducteur Cj orientée verticalement. Le point photosensible comporte une photodiode Dij qui est relié au conducteur colonne par un transistor Tij du type MOS par exemple : dans cet exemple la cathode de la photodiode est reliée à la masse, et son anode est reliée au drain du transistor dont la source est reliée au conducteur colonne ; la grille du transistor étant reliée au conducteur ligne. La lumière est captée par la photodiode qui est périodiquement préchargée et lue grâce au transistor. La sélection ou adressage de la ligne sélectionnée se fait par une impulsion appliquée sur cette ligne et donc sur la grille du transistor de sorte à rendre ce dernier "passant". Par suite le signal circule (sous forme de charges) dans le conducteur colonne, et ce signal est intégré dans un amplificateur intégrateur Aj.

En vue de simplifier la fabrication des matrices photosensibles à l'état solide, il est connu d'utiliser, pour remplir la fonction d'interrupteur ci- dessus mentionné, une diode montée en série avec l'élément photosensible, comme décrit notamment par une demande de brevet français FR-A-2 605 166, déposée au nom de THOMSON-CSF, et qui décrit un dispositif photosensible à l'état solide dans lequel chaque point photosensible est constitué par deux diodes montées en série et tête-bêche, c'est-à-dire avec des sens de conduction opposés : une première diode est reliée à un conducteur ligne et la seconde diode est reliée à un conducteur colonne. Cette demande de brevet décrit en outre un procédé de fabrication de ce dispositif photosensible et un procédé de lecture qui permet à l'une des deux diodes de fonctionner comme un interrupteur "fermé" quand la ligne à lire est adressée, et qui permet ainsi le passage de la charge électrique formant le signal vers l'amplificateur de signal.

L'un des principaux problèmes que pose la lecture de ces types de points photosensibles réside dans une trop forte valeur de la capacité électrique qu'ils présentent. Cette capacité de chaque élément photosensible est appliquée au conducteur colonne et à l'amplificateur de lecture auxquels cet élément est relié, et tend à détériorer le rapport signal/bruit.

Un autre inconvénient présenté également par ce type de points photosensibles est connu par le terme en langue anglaise "smearing", c'est-à-dire la diaphotie qui existe entre le signal issu d'un point photosensible relié à une électrode colonne donnée, et ceux de tous les autres points photosensibles reliés à la même électrode colonne.

Pour améliorer les performances de ces dispositifs photosensibles, de nouvelles structures du point photosensible ont récemment été proposées, dans lesquelles les photocharges collectées ne sont pas lues directement, mais modulent une tension ou un courant. On admet dans ce cas qu'il y a une amplification du signal au niveau du point photosensible lui-même.

Un exemple de réalisation de ce dernier type de points photosensibles est connu par la publication IEEE Transaction on electron device, volume 35, n° 5, Mai 1988, pages 646 à 652. Dans cette réalisation, la détection et l'amplification sont assurées par un transistor à effet de champ à jonction (J FET).

Une autre forme de réalisation est connue par la publication IEDM Tech. Dig. Décembre 1986, pages 353 à 356. Le montage qui est décrit dans cette publication utilise un transistor commun à la fonction d'amplification et à la fonction de détection. Ce transistor est d'un type semblable à un transistor MOS bien que comportant par rapport à ce dernier des différences qui sont apportées pour lui permettre notamment de remplir la fonction détecteur.

Ces deux réalisations présentent entre autres les défauts suivants :
a) pour la réalisation utilisant un transistor J FET :
   - la technologie du J FET est relativement complexe et par suite elle est onéreuse; elle ne peut être mise en oeuvre dans le cadre d'une technologie du type à couche mince ;
   - elle exige l'utilisation de silicium monocristallin, de sorte que par rapport à des montages qui permettent l'utilisation de silicium amorphe, une telle réalisation de points photosensibles présente en outre comme inconvénient qu'il n'est pas possible de réaliser un dispositif photosensible de grande surface, pouvant servir notamment à la détection d'images radiologiques où il est particulièrement intéressant de disposer d'un détecteur d'image surfacique de grande surface, de 40 cm x 40 cm par exemple (il est connu que pour la détection d'images radiologiques il suffit d'ajouter à une matrice photosensible, un écran scintillateur pour convertir les rayons X en photons).
b) Pour la seconde réalisation qui utilise un transistor d'un type ressemblant à un transistor MOS :
   - cette réalisation présente les mêmes défauts que ci-dessus cités à savoir : technologie complexe, obligation d'utiliser du silicium monocristallin ce qui entraîne les mêmes inconvénients que ci-dessus mentionnés; et il semble qu'en plus, cette seconde réalisation présente l'inconvénient de n'être pas protégée contre l'effet de diaphotie (smearing).

La présente invention concerne un dispositif photosensible du type à l'état solide, dont les points photosensibles sont agencés d'une manière nouvelle qui permet une amplification du signal au niveau de chaque point photosensible sans présenter les inconvénients ci-dessus cités, et qui permet en outre d'obtenir une réduction du courant d'obscurité ainsi qu'un meilleur rendement quantique.

La présente invention propose un schéma nouveau d'un point photosensible du type comportant un transistor d'amplification, ce schéma étant applicable avantageusement aussi bien dans le cas de dispositifs photosensibles du type barrette linéaire, que dans le cas de dispositif de type surfacique de moyenne ou faible surface utilisant pour le transistor d'amplification du silicium monocristallin, ou encore dans le cas de dispositif photosensible de grande surface utilisant du silicium amorphe pour la réalisation, entre autres, du transistor d'amplification situé au niveau de chaque point photosensible.

Selon l'invention, un dispositif photosensible comportant au moins un conducteur en ligne croisé avec au moins un conducteur en colonne, un point photosensible étant formé sensiblement à chaque croisement entre un conducteur en ligne et un conducteur colonne, le point photosensible comportant un premier et un second éléments dipôles montés en série et dont au moins un est un élément photosensible, le point ou zone de réunion des deux dipôles constituant un point à potentiel flottant où sont stockées des charges électriques engendrées par une exposition à la lumière du point photosensible, le premier dipôle étant d'autre part relié à un conducteur en ligne par son extrémité ou pôle opposé au point à potentiel flottant, est caractérisé en ce qu'il comporte en outre un élément tripôle du type transistor dont un premier pôle constitue la grille de commande, la grille de commande étant reliée au point à potentiel flottant, un second pôle du transistor étant relié au conducteur colonne, le troisième pôle du transistor étant relié à la fois d'une part à une tension d'alimentation et d'autre part au second dipôle par un pôle ou extrémité de ce dernier opposé au point à potentiel flottant.

L'invention sera mieux comprise à l'aide de la description qui suit, faite à titre d'exemple non limitatif, et à l'aide des 12 figures annexées parmi lesquelles :
- la figure 1, déjà décrite, montre le schéma d'un point photosensible selon l'art antérieur ;
- la figure 2 montre à titre d'exemple non limitatif, le schéma d'un dispositif photosensible ayant une matrice photosensible formée par des points photosensibles conformes à l'invention ;
- la figure 3 montre le schéma électrique d'une variante d'un point photosensible conforme à l'invention ;
- les figures 4a, 4b sont des diagrammes temporels qui illustrent le fonctionnement de la matrice photosensible ;
- la figure 5 est un schéma électrique qui montre le dispositif photosensible d'une même manière que sur la figure 2 à l'exception de moyens de lecture qui sont organisés différemment ;
- la figure 6 représente une courbe tension/courant d'une diode à deux seuils de conduction ;
- la figure 7 montre le schéma électrique d'un point photosensible comportant une diode ayant les caractéristiques représentées à la figure 6;
- les figures 8a, 8b sont des diagrammes temporels qui illustrent le fonctionnement de points photosensibles tels que représentés à la figure 7 ;
- la figure 9 montre de manière schématique, une structure d'un point photosensible utilisant un transistor d'amplification du type circuit intégré et une diode photosensible en silicium amorphe ;
- la figure 10 montre de manière schématique une structure d'un point photosensible utilisant un transistor d'amplification du type circuit intégré, où les deux diodes montrées à la figure 2 sont en silicium amorphe ;
- les figures 11 et 12 montrent de manière schématique un exemple de structure dans laquelle le transistor d'amplification d'un point photosensible est en silicium amorphe, la figure 11 étant une vue de dessus de cette structure et la figure 12 étant une vue en coupe.

La figure 2 montre le schéma électrique d'un dispositif photosensible 1 ayant une matrice 2 de points photosensibles P1, P2... P9. Dans l'exemple non limitatif décrit le nombre de points photosensibles P1, P9 est limité à 9, selon un assemblage matriciel 3 x 3 pour simplifier la figure 2. La matrice 2 comporte des conducteurs en ligne L1 à L3 et des conducteurs en colonnes F1 à F3, le nombre de chaque type de ces conducteurs étant limité à 3, compte-tenu de l'exemple de la figure 2 où seulement 9 points photosensibles P1 à P9 sont représentés ; mais dans l'esprit de l'invention cet assemblage matriciel peut avoir une capacité beaucoup plus grande, de plusieurs millions de points par exemple, à l'aide par exemple de 2 000 conducteurs lignes et 2 000 conducteurs colonnes de sorte à obtenir un détecteur surfacique dont les dimensions sont de l'ordre notamment de 40 cm x 40 cm.

En pratique et de façon classique, les points photosensibles P1 à P9 sont formés chacun à l'intersection d'un conducteur en ligne L1 à L3 et d'un conducteur en colonne F1 à F3.

Selon une caractéristique de l'invention chaque point photosensible P1 à P9 comporte deux éléments dipôles dont au moins un est un élément photosensible, et comporte un élément tripôle constitué par un transistor T. En prenant pour exemple le second point photosensible P2 dont la structure matérielle est réalisée sensiblement au croisement entre le premier conducteur en ligne L1 et le second conducteur en colonne F2, chaque point photosensible P1 à P9 comporte un premier élément dipôle 4 monté en série avec un second élément dipôle 5. Le point ou zone de réunion entre les deux éléments dipôles 4, 5 constitue un point à potentiel flottant A. Comme il a été indiqué précédemment, l'un ou l'autre ou les deux éléments dipôles 4, 5 à la fois sont photosensibles.

Dans une première version de l'invention, les deux éléments dipôles 4, 5 sont constitués par des diodes respectivement Da et Db, dont au moins une, la première diode Da par exemple est une photodiode. La première diode Da est de préférence réalisée de manière à avoir une surface plus importante que la seconde diode Db, 10 fois plus grande par exemple, de sorte que les capacités (non représentées) que présentent ces diodes Da, Db quand elles sont polarisées en inverse soient telles que la capacité de la première diode Da soit plus grande que celle de la seconde diode Db. Il est à noter en outre que dans le cas de cette première configuration, les deux diodes Da, Db sont placées en série et tête-bêche, c'est-à-dire avec des sens de conduction opposés. Dans l'exemple non limitatif décrit, la première diode Da a pour fonction principale la photodétection, et la seconde diode Db est destinée à accomplir une restauration du potentiel au niveau du point à potentiel flottant A, où sont stockées des charges électriques engendrées lors de l'exposition du point photosensible P2 à un rayonnement de lumière (non représenté) visible ou proche du visible ; bien entendu, si la seconde diode Db était également une photodiode, des photocharges engendrées par celle-ci seraient également stockées au point à potentiel flottant A. Un pôle 6 du premier dipôle 4, opposé au point à potentiel flottant A, c'est-à-dire dans cet exemple la cathode de la première diode Da, est relié au premier conducteur L1 ; et la cathode 7 de la seconde diode Db est reliée à un conducteur d'alimentation 8 auquel est appliquée une tension d'alimentation V_{DD}. Bien entendu, les deux diodes Da, Db pourraient être montées avec des sens de conduction différents sous réserve par exemple d'inverser des polarités de tension et d'impulsion de lecture qui seront davantage explicités dans une suite de la description.

Dans l'exemple non limitatif de la figure 2, le tripôle T est représenté comme étant un transistor du type MOS, à canal N par exemple, mais le transistor T pourrait être également un transistor du type à effet de champ à jonction et dans l'un ou l'autre de ces deux types il pourrait être aussi bien du type circuit intégré que du type transistor à couche mince c'est-à-dire du type utilisant du silicium monocristallin que du type pouvant utiliser du silicium amorphe, avec dans ce dernier cas l'avantage de pouvoir être réalisé aisément en grande surface ; il est à noter aussi que le transistor T pourrait être un transistor du type bipolaire.

Le transistor T a pour première fonction, lors de la lecture du point photosensible P2, d'amplifier le signal utile constitué par des charges stockées au point à potentiel flottant A ; et il a pour seconde fonction d'appliquer au conducteur colonne auquel il est relié le signal utile qu'il a amplifié. A cette fin, la grille de commande G du transistor T (laquelle grille de commande G constitue un premier pôle du tripôle T) est reliée au point à potentiel flottant A. D'autre part, le drain Dr du transistor T (lequel drain Dr constitue un second pôle du tripôle) est relié au conducteur d'alimentation 8, c'est-à-dire qu'il est relié à la même tension d'alimentation que la cathode 7 de la seconde diode Db. Enfin la source S du transistor T (laquelle source S constitue le troisième pôle du tripôle T) est relié au conducteur colonne F2.

Chaque point photosensible P1 à P9 est constitué d'une même manière que le second point photosensible P2 qui vient d'être décrit.

D'une manière en elle-même classique, les conducteurs en ligne L1 à L3 sont reliés à un dispositif d'adressage ligne 10 comportant notamment un registre à décalage logique 11 qui permet d'assurer l'adressage séquentiel de chaque ligne L1 à L3 en vue de la lecture aux points photosensibles P1 à P9 qui sont reliés à cette ligne. Le registre 11 commande l'application d' une tension VL sous forme d'impulsions appelées impulsion de lecture IL et impulsion de restauration IR (non représentées sur la figure 2), de conducteurs lignes en conducteurs lignes, alors que les autres conducteurs lignes non adressés sont maintenus à un potentiel de repos VR ; le potentiel de référence VR étant négatif par rapport à la tension d'alimentation continue V_{DD}. Les impulsions IL, IR sont fournies par un générateur d'impulsions de tension 14 dont une sortie 15 est reliée au potentiel de repos VR et dont une seconde sortie 16 est reliée à un dispositif de porte 17 par l'intermédiaire duquel les impulsions IL, IR sont appliquées aux conducteurs lignes L1 à L3, sous la commande du registre à décalage 11.

D'autre part, dans une forme de réalisation indiquée à titre d'exemple non limitatif, chaque conducteur colonne F1 à F3 est relié à l'entrée négative "-" d'un amplificateur opérationnel G1 à G3, monté en intégrateur à l'aide d'un condensateur d'intégration CL1 à CL3. Chaque condensateur d'intégration est monté entre l'entrée négative "-" de l'amplificateur G1 à G3 et la sortie OF1, OF2, OF3 de ce dernier. La seconde entrée ou entrée positive "+" de chaque amplificateur G1 à G3 est reliée à un potentiel de référence colonne Vo qui impose ce potentiel de référence à chaque conducteur colonne F1 à F3, et par suite à chaque source S de chaque transistor T. Dans l'exemple non limitatif décrit, ce potentiel de référence Vo est la masse ou zéro voit et il peut être le même que le potentiel de repos VR du dispositif d'adressage ligne.

Chaque amplificateur G1 à G3 comporte un interrupteur de remise à zéro I1 à I3 monté en parallèle avec le condensateur d'intégration CL1 à CL3 ; sur la figure 2, les interrupteurs I1 à I3 sont représentés selon les interrupteurs, mais ils peuvent bien entendu être constitués de manière classique par les transistors de type MOS par exemple, commandés par des signaux de remise à zéro (non représentés).

Le sorties OF1 à OF3 d'amplificateur G1 à G3 sont reliés à des moyens de lecture et de multiplexage 20, comportant par exemple un dispositif d'acquisition de donnée analogique 21 formée par un registre à décalage à entrée parallèle et sortie S1 série, du type C.C.D. par exemple (du terme anglais "Charge Coupled Device"). Le dispositif d'acquisition de données analogiques 20 peut ainsi sortir en série, de manière classique, des signaux (non représentés) qui correspondent aux charges électriques qui ont été intégrées par les amplificateurs G1 à G3 durant la phase de lecture de tous les points photosensibles reliés à un même conducteur ligne L1 à L3. Bien entendu, d'une manière classique également, il est possible de réaliser un multiplexage des conducteurs colonnes pour ne pas utiliser un amplificateur intégrateur par conducteur colonne : dans ce cas, plusieurs conducteurs colonnes successifs sont reliés successivement dans le temps à un même amplificateur intégrateur à l'aide d'un circuit à multiplexage, comme il est décrit dans des demandes de brevet français déposées au nom de THOMSON-CSF, FR-A-2593343 et FR-A-2592590. Ces demandes de brevet se rapportent à des matrices photosensibles à l'état solide et décrivent en outre l'organisation de moyens d'adressage ligne, ainsi que des procédés de commande et de réalisation de ces matrices.

Il est à noter que dans l'esprit de l'invention, les points photosensibles P1 à P9 peuvent être réalisés d'une manière différente que dans l'exemple de la figure 2.

La figure 3 montre à titre d'exemple non limitatif, le schéma électrique d'une seconde version des points photosensibles P1 à P9. Pour simplifier la description, l'exemple de la figure 3 est limité à la représentation du second point photosensible P2 qui est disposé en croisement du premier conducteur ligne L1 et du second conducteur colonne F2.

Pour cette version, le premier dipôle 4 est constitué par une capacité d'isolement Ci, c'est-à-dire que par rapport à la figure 2, la première diode Da est remplacée par une capacité. La capacité d'isolement Ci peut être une capacité classique, dans ce cas, la seconde diode Db remplit la double fonction d'élément de photodétection et d'élément de commutation ou interrupteur pour restaurer le potentiel au point à potentiel flottant A ; la capacité d'isolement Ci ayant alors uniquement pour fonction d'isoler, en continu, le point à potentiel flottant A. Mais la capacité d'isolement Ci peut avoir aussi comme diélectrique un photoconducteur de haute résistivité, comme le silicium amorphe intrinsèque par exemple, et dans ce cas, la photodétection peut être assurée soit uniquement par la capacité d'isolement Ci ou assurée à la fois par cette dernière et par la seconde diode Db.

Le schéma électrique équivalent (non représenté) de la capacité d'isolement Ci, dans le cas où celle-ci comporte un diélectrique constitué par un matériau photoconducteur de haute résistivité comme par exemple le silicium amorphe intrinsèque, correspond à la capacité Ci avec en parallèle sur cette dernière une résistance électrique variable dont la valeur diminue quand la capacité Ci est exposée à la lumière.

Les figures 4a, 4b représentent des diagrammes temporels qui permettent d'illustrer le fonctionnement dans le cas où les points photosensibles P1 à P9 sont constitués selon l'exemple de la figure 2, où ils comportent deux diodes Da, Db en série. On considère ci-après uniquement le second point photosensible P2, à titre d'exemple valant pour tous les points photosensibles reliés à un même conducteur ligne. Les variations du potentiel ligne VL appliquées au premier conducteur L1 sont représentées sur le diagramme 4a ; les variations de potentiel VA au point à potentiel flottant A sont représentées sur le diagramme 4b. Le cycle de fonctionnement périodique est compris entre un instant t0 et un instant t'0.

Au départ, l'instant t0 correspond à la fin d'un cycle précédent et au début d'une phase d'intégration de lumière TIL d'un cycle nouveau ; à cet instant le potentiel VL appliqué au premier conducteur ligne L1 a une valeur positive par rapport à la tension de repos VR qui est à 0 volt par exemple, et ce potentiel passe à la valeur de la tension de repos VR.

Juste avant l'instant t0, les deux diodes Da, Db sont polarisées en inverse et de ce fait elles se comportent comme des capacités ; la capacité de la première diode Da étant très supérieure (de l'ordre de 10 fois) à la capacité de la seconde diode Db, la variation négative de la tension VL esttransmise au point A et, la tension VA en ce point passe à une valeur VA1 inférieure à la tension de repos VA c'est-à-dire négative par rapport à cette dernière. Par suite, à partir de l'instant t0, la première diode Da est polarisée en inverse et peut stocker l'information lumineuse constituée par des charges électriques, sous forme de porteurs positifs (trous), qui sont accumulés au point à potentiel flottant A pendant toute la période TIL d'intégration lumineuse. Les photoélectrons sont évacués par le potentiel VL s'ils viennent de la première diode Da, ou par l'alimentation V_{DD} s'ils viennent de la seconde diode Db. Pendant la période d'intégration lumineuse TIL, tous les autres conducteurs lignes de la matrice photosensible peuvent être successivement adressés et tous les points photosensibles qui leur sont connectés peuvent d'une part être lus, et d'autre part les potentiels des points A des potentiels flottants peuvent être remis à niveau ou restaurés.

Il est à noter que à l'instant t0, la valeur VA1 de tension VA au point A doit bloquer entièrement le transistor T : en effet, la grille G de commande de ce dernier est reliée au point à potentiel flottant A, c'est-à-dire à la tension VA, et la tension appliquée à la source So du transistor T est fixée à la valeur de référence qui est appliquée aux entrées positives "+" des amplificateurs intégrateurs G1 à G3. Aussi selon que le transistor MOS T est du type canal N à enrichissement ou à déplétion, il suffit pour le bloquer entièrement, dans le premier cas, que sa grille de commande G soit au même potentiel que sa source S, et dans le second cas, il faut que sa grille de commande G soit à un potentiel largement négatif par rapport à la source S pour bloquer le transistor T. Bien entendu, dans le cas où la grille de commande G doit être largement négative par rapport à la source S du transistor T, les entrées positives "+" des amplificateurs intégrateurs G1 à G3 peuvent être reliées à un potentiel de référence Vo positif par rapport à la tension de repos VR. Dans l'exemple non limitatif décrit, il est admis qu'une tension de seuil V_{T}, à partir de laquelle le transistor T conduit, est positive par rapport à la tension de repos VR, et que cette dernière à une même valeur zéro voit ou masse que la tension de référence Vo.

Avec l'exposition du point photosensible P2 à partir de l'instant to, la tension VA au point A tend à devenir plus positive. On a représenté sur la figure 4b différentes évolutions possibles de la tension VA durant la phase d'intégration lumineuse TIL :
- la courbe repérée a (en pointillés) représente une absence d'éclairement, et dans ce ras, la tension VA conserve une même valeur VA1 jusqu'à la fin de la phase d'intégration TIL ; les courants d'obscurité ayant été négligés ;
- la courbe en traits pleins repérée b représente un éclairement moyen, inférieur à la saturation. Dans ce cas, et en supposant que l'intensité de l'éclairement soit constante, la tension VA passe progressivement de la valeur VA1 à une valeur VA2 plus positive, qui est atteinte à la fin de la phase d'intégration TIL ;
- la courbe en traits (pointillés) repérée c, représente un éclairement supérieur à la saturation. Dans ce cas, la tension VA croît beaucoup plus rapidement que dans le cas de la courbe b, pour atteindre à un instant t1 une valeur VA3 qui correspond à la saturation et qui est plus positive que la tension de repos VR. En conséquence pour ce cas, la première diode Da passe en direct, ce qui permet la recombinaison des porteurs en excès et assure ainsi la fonction anti-éblouissement du dispositif. Pour un fonctionnement correct de cette fonction, on voit qu'il est nécessaire que la tension de repos VR soit suffisamment inférieure à la tension de seuil VT du transistor T pour éviter la mise en conduction de ce dernier.

Il est à noter que dans l'ensemble du cycle de fonctionnement, la possibilité d'atteindre la valeur VA3 dite de saturation correspond à la seule période durant laquelle la première diode Da peut éventuellement passer en direct, et que dans tout le reste du cycle elle est polarisée en inverse et se comporte donc comme une capacité. Aussi le fonctionnement qui est décrit en référence aux figures 4a et 4b s'applique également à la version du point photosensible représenté en figure 3 où l'élément dipôle 4 est constitué par une capacité d'isolement Ci. Il est à noter cependant que la fonction anti-éblouissement dans le cas du point photosensible montré à la figure 3, est avantageusement assurée si le diélectrique de la capacité d'isolement Ci est un diélectrique photoconducteur. En effet, dans ce cas, lorsque la tension VA se rapproche de la tension de repos VR, le champ électrique entre les armatures de la capacité Ci et donc dans le matériau photoconducteur diminue, ce qui réduit la photodétection, jusqu'à l'annuler pour un champ nul lorsque la tension VA est égale à la tension VR aux très forts éclairements. On obtient également un effet de compression de dynamique ("Gamma"), la photosensibilité diminuant avec l'augmentation de l'éclairement.

A la fin de la phase d'intégration TIL, à un instant t2 où commence une phase de lecture TL, la tension ligne VL passe à une valeur VL2 positive par rapport à la valeur précédente VR et inférieure à la tension d'alimentation V_{DD}; tandis que le potentiel de repos VR est maintenu sur tous les autres conducteurs lignes non adressés. Cette variation de la valeur VR à la valeur VL2 de la tension VL constitue le front avant d'une impulsion de lecture IL.

Si l'on considère le cas illustré par la courbe repérée b d'un éclairement moyen (le fonctionnement dans le cas des courbes repérées a et c se déduisant sans difficulté), à l'instant t2, le front de montée de l'impulsion de lecture IL est transmis au point A à potentiel flottant par la capacité que constitue la première diode Da, cette dernière étant polarisée en inverse. La tension VA passe alors de la valeur VA2 à une valeur VA4 qui est supérieure à la tension de seuil VT du transistor T ceci rend le transistor T conducteur, ce qui permet de recueillir sur la colonne F2 un signal utile amplifié en courant par le transistor T et qui est proportionnel au signal stocké au point à potentiel flottant A. Le signal utile amplifié injecté dans le conducteur colonne F₂ est appliqué à l'amplificateur intégrateur G2 d'une manière en elle-même classique, et il est à noter que l'interrupteur de remise à zéro I2 est maintenu à l'état "fermé" pour court-circuiter le condensateur d'intégration CL2 durant tout le cycle de fonctionnement à l'exception de la phase de lecture TL où cet interrupteur I2 est mis à l'état "ouvert".

Il est à remarquer que dans le cas du montage représenté à la figure 2, le transistor T procure une amplification en courant, mais que d'autres montages peuvent être utilisés qui permettent d'obtenir une amplification en tension, comme il sera décrit après la présente explication relative au fonctionnement.

Il est important de noter que dans tous les cas la lecture est non destructive : le signal reste stocké au point à potentiel flottant A, et éventuellement, plusieurs lectures successives sont possibles, si l'on fait se succéder plusieurs impulsions de lecture IL ; la fin d'une impulsion de lecture devant être dans ce cas constituée par une variation de la tension ligne VL de la valeur VL2 à la valeur de repos VR.

Dans l'exemple non limitatif décrit, une seule lecture est réalisée et l'impulsion de lecture IL est suivie d'une impulsion de restauration IR de sorte qu'il n'est pas utile de ramener la tension ligne VL à la valeur de la tension de repos VR. La phase de restauration de potentiel TR du point A à potentiel flottant suit immédiatement la phase de lecture TL, et l'impulsion de restauration IR a une amplitude positive plus grande que l'impulsion de lecture IL. A l'instant t3 le front avant de l'impulsion de restauration IR porte la tension ligne VL a une valeur VL3, et la variation entre les valeurs VL2 et VL3 est transmise au point A par la capacité présentée par la première diode Da. La tension VA au point A augmente alors et passe de la valeur VA4 à une valeur VA5 qui est largement supérieure à la valeur de la tension d'alimentation V_{DD}. En fait la valeur VL3 de la tension ligne VL est choisie pour que, si possible, la valeur VA5 de la tension VA soit largement supérieure à la tension d'alimentation V_{DD} à laquelle on ajoute la tension de seuil de conduction ou tension de coude V_{C} de la seconde diode Db qui est la diode de restauration de potentiel. Dans cette configuration, à l'instant t3, la tension VA au point A ayant la valeur VA5, la seconde diode Da passe en polarisation directe, de sorte que cette dernière décharge le point à potentiel flottant A jusqu'à une valeur VA6 formée de la valeur de la tension d'alimentation V_{DD} à laquelle est ajoutée la tension de coude V_{C} de la seconde diode Db. Il en résulte que les photoporteurs stockés au point potentiel flottant A sont ainsi évacués sur la connexion de tension V_{DD}. La tension ligne VL est ensuite ramenée à la tension de repos VR à un instant t'0 qui correspond à la fin de la phase de restauration TR, et qui marque le début d'une nouvelle phase d'intégration lumineuse TIL pour cette ligne, alors que les impulsions de lecture et de restauration IL, IR peuvent être appliquées à un conducteur ligne suivant.

Il est à noter que durant la phase de lecture TL seul le transistor T du second point photosensible P2 appartenant au conducteur ligne sélectionné c'est-à-dire au premier conducteur ligne L1, débite un courant sur la colonne F2, tous les autres transistors de la même colonne étant maintenus bloqués par le niveau de la tension ligne VL appliqué sur les autres conducteurs lignes. Néanmoins, il est possible si besoin est, de débloquer l'un quelconque d'autres transistors, c'est-à-dire d'autres conducteurs lignes pour permettre une lecture simultanée de deux ou plusieurs points de la colonne : les courants sont alors sommés dans le cas d'une lecture en courant.

La figure 5 montre à titre d'exemple non limitatif, un dispositif photosensible 1 qui diffère de celui montré à la figure 2, uniquement en ce qui concerne les éléments utilisés pour la lecture des points photosensibles P1 à P9. Dans l'exemple non limitatif montré à la figure 5, cette lecture est une lecture en tension pour laquelle on utilise un transistor TS du type MOS à déplétion, polarisé en saturation : la grille G1 et la source Sₛde ce dernier étant reliées ensemble et à la masse ou tension de référence Vo ; et chacun des conducteurs colonnes F1 à F3 est relié à un élément de commutation M1, M2, M3 par l'intermédiaire duquel il est relié au drain Dₛ du transistor TS. Une capacité Cₛ est montée entre le drain Dₛ et la masse ou tension de référence Vo. Les éléments de commutation M1, M2, M3 peuvent être des transistors MOS reliés respectivement par leur drain au premier, second et troisième conducteurs colonnes F1, F2, F3 et dont les sources sont reliées entre elles et reliées au drain Dₛ du transistor de sortie TS. Chaque grille de commande GM1, GM2, GM3 des éléments de commutation M1, M2, M3 est reliée à une sortie 30, 31, 32 d'un registre horizontal R_{H} constitué d'un registre à décalage classique et qui commande séquentiellement la conduction des éléments de commutation M1 à M3. La lecture est une lecture en tension, le temps nécessaire à cette lecture peut être très court, et il est ainsi possible de connecter séquentiellement tous les conducteurs colonnes F1 à F3 durant le temps de la phase de lecture TL.

Au moment de la connection d'un connecteur colonne F1 à F3 sur le transistor TS, l'ensemble du transistor amplificateur T et le transistor de sortie TS réalise un suiveur de tension qui recopie au niveau du drain Dₛ la tension VA qui existe au point à potentiel flottant A. Il y a un gain de lecture très important en charge signal, car la capacité Cₛ est très supérieure à la capacité C_{A} (non représentée) présente au point à potentiel flottant A, le gain étant égal au rapport Cₛ/C_{A}. Le drain Dₛ du transistor de sortie TS constitue une sortie S1' qu'il est possible d'appliquer à un dispositif d'acquisition classique (non représenté) pour stocker et traiter des résultats.

Il est à signaler que pour obtenir une bonne efficacité de lecture des points photosensibles, même au bas niveau de lumière, il existe un problème qui est commun à toutes les structures de points photosensibles dans lesquels une diode est en série avec le point à potentiel flottant où sont stockées les charges. Ce problème vient du fait notamment que, aux bas niveaux de lumière, le point à potentiel flottant A où sont stockées les charges accuse une faible variation de potentiel et, par suite, les impulsions de tension appliquées au point à potentiel flottant et qui se superposent au potentiel existant en ce point, ne permettent pas de polariser la diode en direct assez au-delà de son seuil de conduction pour que cette diode présente une résistance dynamique suffisamment faible pour écouler les charges stockées. L'un des inconvénients qui en résulte est que les charges non écoulées restent au point à potentiel flottant et sont ajoutées aux charges engendrées par l'intégration lumineuse du cycle suivant ; chaque mesure conserve ainsi la mémoire de la mesure précédente (phénomène de rémanence) et il en résulte une erreur sur la lecture. Ainsi en prenant pour exemple le diagramme de la figure 4b, il est nécessaire que la tension VA5 à l'instant t3 du début de la phase de restauration TR ait une valeur suffisamment élevée pour que la différence de potentiel VA5 - V_{DD} développée aux bornes de la seconde diode Db dépasse largement la valeur du seuil de conduction ou tension de coude V_{C} de cette dernière qui ainsi peut présenter une résistance, "en direct", suffisamment faible pour écouler par la tension d'alimentation V_{DD} toutes les charges qui étaient stockées au point flottant A, et ceci dans un temps inférieur à la durée des phases de restauration TR ; de sorte qu'au début de chaque nouvelle phase d'intégration lumineuse, le potentiel du point flottant A ait toujours une même valeur.

Il peut être remédié au défaut ci-dessus mentionné en introduisant une quantité de charges additionnelles appelées charges d'entraînement. Différentes méthodes peuvent être avantageusement utilisées pour introduire cette quantité de charges additionnelles, telles que celles enseignées par exemple dans une demande de brevet français FR-A-2593319 au nom de THOMSON-CSF, dans laquelle cette charge additionnelle est appelée "fond de charge ou charge de polarisation". La méthode la plus simple consiste à produire un éclairement additionnel qui s'ajoute à l'éclairement produit par le signal de lumière utile. Cette solution présente comme inconvénient notamment de nécessiter une source d'éclairement additionnelle, et sur le plan électrique d'être une source de bruit lors de la lecture.

Il est possible, avec les points photosensibles P1 à P9 conformes à l'invention de réaliser de manière simple une remise à niveau ou restauration correcte du point A à potentiel flottant après chaque phase de lecture, sans exiger de source de lumière additionnelle, mais en remplaçant la seconde diode Db qui assure une fonction de commutation pour la restauration, par un élément de commutation ayant une caractéristique à deux seuils. Aussi, dans cette version de l'invention, la seconde diode Db dite de restauration est remplacée par une diode qui peut être mise en conduction directe si une tension de polarisation directe à ses bornes devient supérieure à un premier seuil de tension Vs1, et qui peut être mise en conduction inverse si une tension de polarisation inverse devient supérieure à un second seuil de tension Vs2. Dans ces conditions, la seconde diode ou diode de restauration, repérée Dbz, a une caractéristique courant/tension du genre représenté sur la figure 6, analogue à celle d'une diode zener. Il est à noter que dans ce cas, la seconde diode Dbz, de restauration, constitue une capacité quand elle n'est pas en conduction, capacité qui comme dans le cas précédent est faible devant la capacité présentée le premier dipôle 4 (la première diode Da dans l'exemple).

Ainsi par exemple on sait réaliser de telles diodes dont la mise en conduction directe a lieu pour un premier seuil de tension positif d'environ + 1 Volt et dont la mise en conduction inverse a lieu pour un second seuil de tension négatif qui peut être compris par exemple entre - 2 Volts et - 15 Volts et donc ajustable par un choix approprié.

La figure 7 montre à titre d'exemple non limitatif, un schéma électrique d'un point photosensible, le second point photosensible P2 par exemple, dans une version où la seconde diode ou diode de restauration repérée Dbz est du type dont la caractéristique est représentée à la figure 6, c'est-à-dire avec un premier seuil de conduction en direct Vs1 et un second seuil de mise en conduction inverse Vs2. Par rapport au schéma électrique du point photosensible de la figure 2 par exemple la différence réside dans le fait que la diode de restauration Dbz est du type à deux seuils de conduction comme il a été ci-dessus mentionné ; et d'autre part, la figure 7 illustre que le sens de montage de la première diode Da peut être modifié, cette dernière étant sur la figure 7 reliée au premier conducteur ligne L1 par son anode et au point A de potentiel flottant par sa cathode, l'anode de la diode de restauration Dbz étant également reliée au point A à potentiel flottant.

Bien entendu dans cette configuration, les charges stockées au point à potentiel flottant A sont des électrons, de sorte qu'avec l'exposition à la lumière, le point à potentiel flottant A VA tendre vers des potentiels négatifs au contraire de l'exemple illustré à la figure 4b.

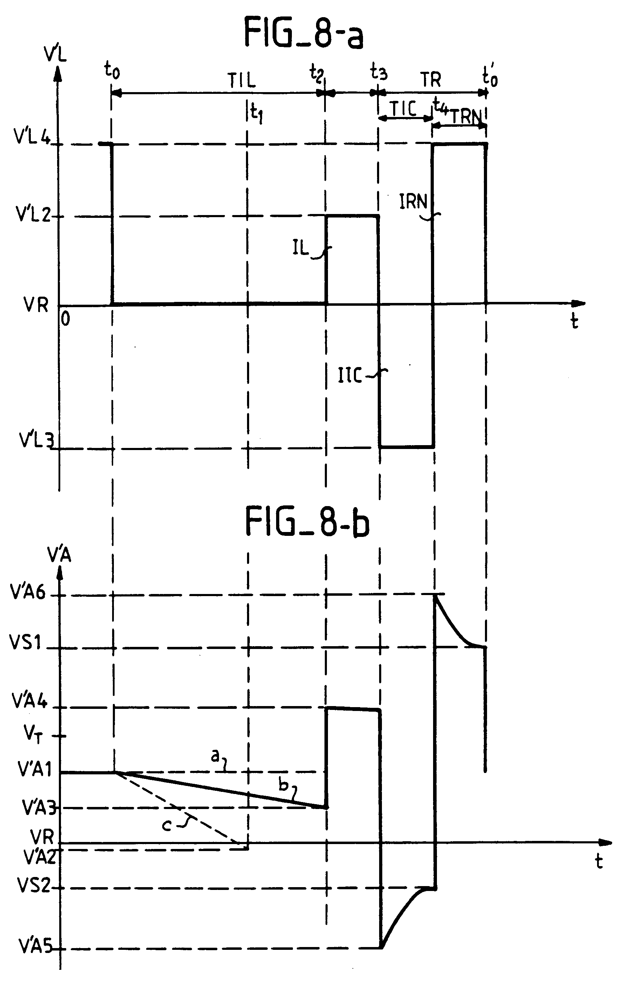

La figure 8a représente des variations du potentiel ligne V'L appliquées au conducteur en ligne adressé, c'est-à-dire le premier conducteur en ligne L1 dans l'exemple auquel est relié le second point photosensible P2 ; la figure 8b représente les variations du potentiel V'A au point à potentiel flottant A.

L'instant t0 marque la fin d'un cycle et le début d'un cycle nouveau qui débute par une phase d'exposition à la lumière c'est-à-dire d'intégration lumineuse TIL.

A l'instant t0 : on ramène le potentiel appliqué au conducteur en ligne L1 à sa valeur de repos VR. Tous les autres conducteurs en ligne non sélectionnés sont également à la valeur de repos VR ;
- au point à potentiel flottant A, la tension V'A est à une valeur V'A1 qui résulte de la fin du cycle précédent. La valeur V'A1 est inférieure à la tension de seuil de conduction V_{T} du transistor T. D'autre part, la valeur V'A1 est supérieure à la valeur de repos VR du potentiel ligne de sorte que la première diode Da est polarisée en inverse ; par suite elle stocke des charges (électrons) en fonction de l'intensité de la lumière auquel le point photosensible P2 est exposé. Comme dans l'exemple de la figure 4b, une courbe repérée a (en traits pointillés) illustre le cas d'un éclairement nul, et dans ce cas la tension V'A conserve la valeur V'a1 jusqu'à la fin de la phase d'intégration lumineuse TIL ; une autre courbe repérée c (en traits pointillés) illustre le cas d'une très forte intensité de lumière qui conduit à la saturation, et dans ce cas, le potentiel V'A du point flottant A diminue avec une forte pente et tend vers les potentiels négatifs pour atteindre une valeur VA'2 à un instant t1, où la première diode Da passe en conduction directe ; un cas d'éclairement moyen est représenté par la courbe repérée b (en traits pleins) : dans ce cas la tension V'A diminue pour atteindre une valeur V'A3 comprise entre les valeurs VR et V'A2.

A l'instant t2, débute la phase de lecture TL, c'est-à-dire qu'à l'instant t2 une impulsion de lecture IL est appliquée uniquement au conducteur ligne L1 adressé (il est à noter que l'interrupteur de remise à zéro I2 qui fonctionne avec l'amplificateur intégrateur G2 est mis à l'état "ouvert" uniquement durant la phase de lecture TL). Avec le front de montée de l'impulsion positive de lecture IL, le potentiel de ligne V'L passe de la valeur de repos VR à une valeur V'L2 et la variation c'est-à-dire la différence V'L2 - VR est transmise pour l'essentiel au point à potentiel flottant A. La tension V'A au point A passe de la valeur V'A3 (pour le cas de la courbe 2 de l'éclairage moyen) à une valeur V'A4 qui est plus grande que le seuil de conduction V'T du transistor T, d'où il résulte une lecture de la charge emmagasinée au point A.

L'instant t3 correspond à la fin de la phase de lecture TL et au début d'une phase d'injection de charges TIC qui est marquée par une variation négative de la tension ligne V'L : la tension ligne V'L diminue au point de devenir négative par exemple à une valeur V'L3. La variation ou différence V'L2 - V'L3 est transmise au point A où la tension V'A passe à une valeur V'A5 plus négative que le seuil de conduction inverse Vs2 de la seconde diode Dbz ou diode de restauration. Cette diode de restauration est alors polarisée en inverse avec à ses bornes une différence de tension suffisamment grande pour que la diode Dbz présente alors une résistance dynamique faible (la tension V'L3 doit être rendue suffisamment négative pour que même sans éclairement, la seconde diode Dbz soit polarisée à partir de l'instant t3 dans une région où sa résistance dynamique est faible). L'instant t3 marque ainsi le début d'une impulsion d'injection de charges qui dure jusqu'à un instant t4, et dont le signe est contraire à celui de l'impulsion de lecture IL. Par suite, à partir de l'instant t3, la diode de restauration Dbz conduit (en inverse) et sa résistance interne est assez faible pour ramener la tension V'A au point A à la valeur correspondant à son seuil de conduction inverse Vs2, avant l'instant t4. Ceci correspond à injecter des charges au point à potentiel flottant A qui s'ajoutent aux charges engendrées par l'éclairement, et qui permettent de ramener le potentiel V'A toujours à une même valeur qui est le seuil de conduction inverse Vs2 ; et ceci pour une intensité quelconque de l'éclairement auquel a été soumis le point photosensible pendant la phase d'intégration de la lumière.

A l'instant t4, le potentiel ligne V'L s'inverse pour constituer une impulsion IRN qui dure jusqu'à un instant t'0 qui marque le début d'un cycle suivant. A l'instant t4, le potentiel ligne V'L est passé de la valeur V'L3 à une valeur V'L4 plus positive. La première diode Da étant polarisée en inverse, elle se comporte comme une capacité et transmet presque complètement au point A à potentiel flottant la variation V'L4 - V'L3 appliquée au potentiel ligne à l'instant t4. Au point A à potentiel flottant, le potentiel V'A passe alors de la valeur du seuil de conduction inverse Vs2 à une valeur V'A6 supérieure à la valeur du seuil de conduction en direct Vs1 de la seconde diode ou diode de restauration Dbz ; par suite cette dernière est mise en conduction directe avec une résistance dynamique suffisamment faible pour que jusqu'à l'instant t'0, le potentiel V'A au point A évolue jusqu'à la valeur du seuil de conduction directe Vs1. La condition pour que dans ce cas la résistance dynamique de la diode soit faible est que, à l'instant t4, la différence V'L4 - V'L3 soit sensiblement supérieure à l'écart entre les tensions de seuil de conduction directe et de seuil de conduction inverse Vs1 - Vs2 , soit V'A6 - V'A5 plus grand que Vs1 - Vs2.

L'instant t'0 marque la fin de l'impulsion de remise à niveau IRN dont la durée ajoutée à celle de l'impulsion d'injection de charges IIC constitue la phase de restauration TR ; le potentiel ligne V'L repassant à la valeur de repos V'L1 à l'instant t'0.

Cette description de l'agencement des points photosensibles P1 à P9 et des méthodes d'adressage et de lecture est donnée à titre d'exemple non limitatif, et des modifications peuvent être apportées tout en restant dans le cadre de l'invention. Ainsi par exemple, avec un mode de fonctionnement très voisin de celui expliqué, mais sur la base d'un mode d'adressage un peu modifié, on peut, notamment dans le cas illustré à la figure 7, inverser le sens de conduction de la première diode Da de sorte que les deux diodes Da, Db ou Dbz sont montées tête-bêche. Il est également possible en modifiant le mode d'adressage de faire passer la première diode Da en direct pendant la période de restauration TR, de sorte à obtenir un effacement d'une éventuelle rémanence introduite par des porteurs piégés dans le silicium amorphe. Egalement on peut permuter les places des première et seconde diodes uniquement en modifiant les signaux de commande. Il est à signaler en outre que le premier élément dipôle 4 peut être constitué non seulement par une diode Da ou par une capacité Ci, mais qu'il peut être constitué également par un phototransistor avec base flottante du type NIPIN par exemple, ce qui permet d'améliorer encore la photosensibilité du dispositif. Un transitor NIPIN est une structure à 5 couches semiconductrices superposées, qui est facilement réalisable en silicium amorphe : par dépôts successifs d'une couche de silicium de type N, d'une couche de silicium intrinsèque relativement épaisse, d'une couche très mince de type P, d'une couche très mince intrinsèque, et d'une couche de type N.

Il est à noter qu'avec les schémas de points photosensibles proposés par la présente invention, la fonction photodétection est indépendante de la fonction amplificatrice assurée par le transistor T, de sorte que quel que soit le type de réalisation technologique choisi pour le transistor d'amplification T, il est possible de réaliser les éléments de photodétection Da, Ci, Db, en silicium amorphe, et ainsi de bénéficier du faible courant d'obscurité et du meilleur rendement quantique que procure ce matériau.

Ainsi par exemple, si le dispositif photosensible est destiné à la prise de vues télévision (télévision haute définition), le transistor T peut être réalisé en silicium monocristallin avec canal en volume (pour réduire son bruit).

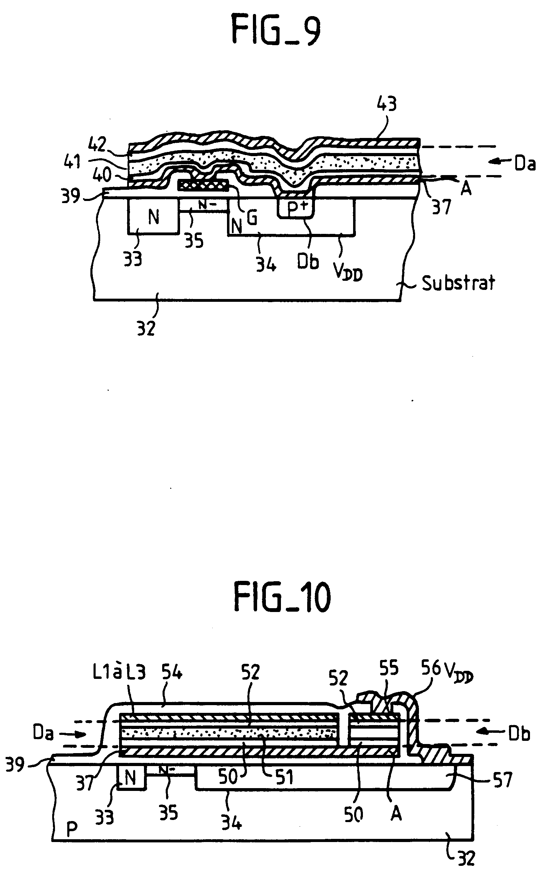

La figure 9 est une vue en coupe qui montre schématiquement la structure d'un point photosensible selon l'invention, où le transistor T est formé sur un substrat en silicium monocristallin.

Sur un substrat 32 de type P, on réalise le transistor de type MOS en volume, par des implantations de type N pour former la source 33 et le drain 34 et N- pour former le canal 35. Toutes les sources 33 sont reliées selon des colonnes qui s'étendent perpendiculairement au plan de la figure. Tous les drains 34 sont reliés à la tension d'alimentation V_{DD}. Dans le drain 34 est réalisée une jonction P+N qui constitue la seconde diode Db. Par ailleurs, au-dessus de la zone N- est formée une métallisation qui constitue la grille G du transistor T et qui est séparée de la zone N- par une couche isolante 39. Une couche métallique électriquement conductrice et opaque 37 recouvre l'ensemble, et constitue le point A à potentiel flottant, et réalise en outre la liaison électrique pour la grille G du transistor et l'anode P+ de la seconde diode Db. Sur la couche métallique 37 formant le point A, sont ensuite déposées, de manière uniforme sur l'ensemble, trois couches semiconductrices destinées à former la première diode Da selon une diode de type PIN en silicium amorphe à savoir : en premier, une couche 40 de silicium amorphe hydrogénée dopée avec une impureté de type P, du bore par exemple ; puis une couche 41 en silicium amorphe hydrogénée intrinsèque ; puis une couche 42 de silicium amorphe hydrogénée dopée avec une impureté de type N, du phosphore par exemple. Enfin, de manière classique, on trouve ensuite une couche métallique conductrice transparente 43 en oxyde d'indium-étain par exemple (ITO) qui est gravée perpendiculairement aux colonnes 32 de sorte à réaliser les conducteurs lignes. Les points photosensibles ainsi constitués sont exposés à la lumière du côté de la couche 43 formant les conducteurs lignes.

Les avantages de cette structure sont notamment de permettre d'obtenir de très bonnes caractéristiques du transistor, des ouvertures optiques maximum, une immunité totale au "smearing", et des contacts grilles du transistor à la diode Db faciles à réaliser.

La figure 10 représente un autre mode de réalisation où le transistor T est également du type MOS en circuit intégré comme dans l'exemple de la figure 8, c'est-à-dire réalisé à partir de silicium monocristallin. Dans l'exemple non limitatif décrit, les deux diodes Da, Db sont également réalisées avec du silicium amorphe. Mais dans cette dernière configuration, la seconde diode Db participe aussi à la photodétection, et à cet effet elle est placée sur un même plan que la première diode Da.

On trouve comme dans l'exemple précédent, le substrat 32 en silicium monocristallin de type P, ainsi que les implantations de type N 33, 34 et de type N- 35 pour réaliser respectivement la source, le drain et le canal. Au-dessus de cet ensemble, on trouve une couche isolante 39, puis la couche métallique opaque 37 qui représente le point A à potentiel flottant et réalise la grille G du transistor ainsi que la liaison de cette grille et les deux diodes Da, Db. On trouve au-dessus de la couche métallique opaque 37, un empilement de trois couches semiconductrices 50, 51, 52 qui, après gravure, permettent de constituer la première et la seconde diodes Da, Db de type PIN : la première couche 50 est en silicium amorphe hydrogénée dopée avec une impureté de type P, du bore par exemple, la couche suivante 51 est une couche plus épaisse en silicium amorphe hydrogénée intrinsèque ; la couche suivante 52 est en silicium amorphe hydrogénée dopée avec une impureté de type N, du phosphore par exemple. Dans l'exemple montré à la figure 9, les deux diodes Da, Db sont ainsi montées tête-bêche c'est-à-dire avec des sens de conduction opposés. On trouve au-dessus des trois couches 50, 51, 52 une couche métallique conductrice transparente (ITO) qui après gravure, constitue les conducteurs lignes. Une couche isolante transparente 54 recouvre l'ensemble à l'exception d'une partie du dessus 55 qui est en contact avec une couche métallique conductrice 56, laquelle couche métallique conductrice 56 est également en contact avec une extrémité 57 du drain 34 de sorte à réaliser la liaison électrique entre ce dernier et la cathode de la seconde diode Db, cette couche métallique conductrice 56 étant reliée à la tension d'alimentation V_{DD}.

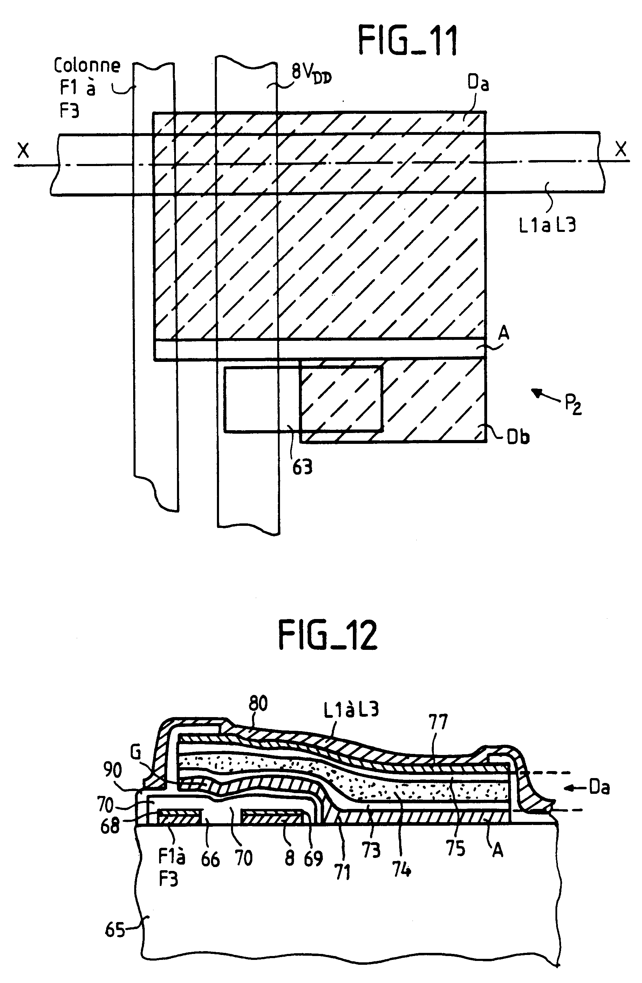

Les figures 11 et 12 illustrent à titre d'exemple non limitatif, une forme de réalisation technologique dans le cas où le transistor d'amplification T est du type transistor à couche mince (en langue anglaise TFT de Thin Film Transistor) ; la représentation de la structure étant limitée à un unique point photosensible.

La figure 11 est une vue de dessus qui illustre notamment les positions relatives des deux diodes Da, Db et des conducteurs colonnes et lignes F1 à F3 et L1 à L3 ainsi que des conducteurs d'alimentation 8 reliés à la tension d'alimentation V_{DD}. On trouve sur le côté gauche de la figure 11, un conducteur colonne F1 à F3 et un conducteur d'alimentation 8, ces conducteurs étant parallèles. Dans un plan moins profond que les conducteurs colonnes et d'alimentation, un premier rectangle hachuré en traits pointillés représente la première diode Da et un second rectangle de plus faible surface que le premier, également hachuré en traits pointillés, représente la seconde diode Db. On trouve également un conducteur ligne L1 à L3 situé dans un plan moins profond que les deux diodes Da, Db. La figure 11 montre également un rectangle 63 situé dans un plan compris entre le conducteur d'alimentation 8 et le conducteur ligne L1 à L3 et qui réalise une fonction de liaison électrique entre la cathode de la seconde diode Da et le conducteur d'alimentation 8. Il est à noter qu'il existe aussi une surface métallisée conductrice qui réalise la liaison électrique entre les deux diodes Da, Db ainsi qu'avec la grille G du transistor amplificateur T, et qui représente le point A à potentiel flottant.

La figure 12 montre schématiquement, le même point photosensible que la figure 10, mais par une vue en coupe réalisée selon un axe X-X représenté sur la figure 11, cet axe étant situé au niveau du conducteur ligne L1 à L3, et formant la ligne d'une coupe réalisée perpendiculairement au plan de la figure 11.

Dans cette version, le substrat 65 est en verre par exemple. Sur le substrat 65, le dépôt d'une couche métallique conductrice permet, après gravure, de réaliser deux conducteurs parallèles dont l'un est un conducteur colonne F1 à F3 et l'autre un conducteur d'alimentation 8 relié à la tension d'alimentation fixe V_{DD} ; ces deux conducteurs étant séparés par un intervalle 66. Les deux conducteurs F1 à F3 et 8 sont recouverts chacun d'une couche 68, 69 de silicium amorphe dopée N, destinées respectivement à constituer la source et le drain du transistor T d'amplification. On trouve ensuite au-dessus des couches 68, 69 dopées N et dans l'intervalle 66, une couche 70 de silicium amorphe hydrogénée intrinsèque. Puis au-dessus de cette couche 70 est déposée une couche isolante 90 en nitrure de silicium par exemple, au-dessus de laquelle on trouve ensuite une couche métallique conductrice 71, opaque, qui s'étend également sur une partie du substrat ou support en verre 65. Cette couche 71 métallique est destinée à constituer le point A à potentiel flottant, et une partie de cette couche 71 située au-dessus de la couche 70 de silicium amorphe hydrogénée intrinsèque, et plus particulièrement au-dessus de l'intervalle 66 qui sépare les deux couches 68, 69 dopées N, est destinée à constituer la grille de commande G du transistor T de type MOS. Au-dessus de la couche métallique 71 formant le point A, on trouve trois couches 73, 74, 75 de silicium amorphe hydrogénée : en premier la couche 73 dopée avec une impureté de type P, puis la couche 74 en silicium intrinsèque, puis la couche 75 en silicium dopée N ces trois couches 73, 74, 75 constituant la première diode Da de type PIN. Une couche métallique conductrice 77, transparente, (ITO) recouvre la couche 75 de la première diode Da en vue de réaliser une bonne répartition des champs électriques. L'ensemble est recouvert d'une couche métallique conductrice 80 qui est gravée de sorte à constituer un conducteur ligne L1 à L3. La seconde diode Db n'est pas montrée sur la figure 11, car compte-tenu du plan de la coupe, cette seconde diode Db se trouve située dans un plan plus rapproché que le plan de la figure. Néanmoins on comprend que les deux diodes Da et Db peuvent être réalisées à partir des mêmes couches semiconductrices 73, 74, 75 puis séparées (comme montrées sur la figure 11) par une opération de gravure. Les diodes Da, Db sont exposées au signal de lumière du côté de la couche conductrice 80 servant à constituer les conducteurs lignes L1 à L3.

La description relative aux figures 9, 10, 11 et 12 a pour objet principalement de montrer l'architecture et la disposition relative des éléments des points photosensibles dont le schéma électrique est donné notamment aux figures 2, 3 et 7 ; les techniques nécessaires pour réaliser les structures montrées, aussi bien dans le cas des réalisations des transistors T dans la technique des circuits intégrés que dans le cas de réalisation de ces transistors dans la technique des couches minces, étant en elle-même connue. Bien entendu, d'autres formes de réalisation peuvent conduire à constituer des points photosensibles selon les schémas des figures 2, 3, 7 sans sortir pour autant du cadre de l'invention.

## Revendications

1. Dispositif photosensible comportant au moins un conducteur en ligne (L1 à L3) croisé avec au moins un conducteur en colonne (F1 à F3), un point photosensible (P1 à P9) étant disposé sensiblement à chaque croisement entre un conducteur en ligne (L1 à L3) et un conducteur colonne (F1 à F3), le point photosensible (P1 à P9) comportant un premier et un second éléments dipôles (4, 5) montés en série et dont au moins un est un élément photosensible, le point ou zone de réunion des deux dipôles (4, 5) constituant un point (A) à potentiel flottant où sont stockées des charges électriques engendrées par une exposition à la lumière du point photosensible, le premier dipôle (4) étant relié à un conducteur en ligne (L1 à L3) par son extrémité ou pôle opposé au point à potentiel flottant (A), caractérisé en ce qu'il comporte en outre un élément tripôle (T) du type transistor dont un premier pôle (G) constitue la grille de commande, la grille de commande (G) étant reliée au point à potentiel flottant (A), un second pôle (S) du transistor (T) étant relié au conducteur colonne (F1 à F3), le troisième pôle (Dr) du transistor (T) étant relié à la fois d'une part à une tension d'alimentation (V_{DD}), et relié d'autre part au second dipôle (5) par un pôle ou extrémité de ce dernier opposé au point à potentiel flottant (A).

2. Dispositif photosensible selon la revendication 1, caractérisé en ce que le premier élément dipôle (4) est une diode (Da).

3. Dispositif photosensible selon la revendication 2, caractérisé en ce que la diode (Da) est en silicium amorphe.

4. Dispositif photosensible selon la revendication 1, caractérisé en ce que le premier élément dipôle (4) est un transistor à base flottante (4).

5. Dispositif photosensible selon la revendication 4, caractérisé en ce que le transistor à base flottante (4) est constitué en silicium amorphe.

6. Dispositif photosensible selon la revendication 1, caractérisé en ce que le premier dipôle (4) est une capacité d'isolement (Ci).

7. Dispositif photosensible selon la revendication 6, caractérisé en ce que le diélectrique de la capacité d'isolement (Ci) est en un matériau photoconducteur du type silicium amorphe intrinsèque.

8. Dispositif photosensible selon l'une des revendications précédentes, caractérisé en ce que le second élément dipôle (5) est une diode (Db) dite diode de restauration.

9. Dispositif photosensible selon la revendication 8, caractérisé en ce que la diode de restauration (Db) est en silicium amorphe.

10. Dispositif photosensible selon la revendication 1, caractérisé en ce que le premier et le second éléments dipôles (4, 5) sont constitués par des diodes (Da, Db) montés en série avec des sens de conduction opposés.

11. Dispositif photosensible selon l'une des revendications précédentes, caractérisé en ce que le transistor (T) est constitué à partir de silicium monocristallin.

12. Dispositif photosensible selon la revendication 11, caractérisé en ce que le transistor (T) est du type MOS.

13. Dispositif photosensible selon l'une quelconque des revendications 1 à 10, caractérisé en ce que le transistor (T) est constitué à partir de silicium amorphe.

14. Dispositif photosensible selon la revendication 13, caractérisé en ce le transistor (T) est du type transistor à couche mince.

15. Dispositif photosensible selon la revendication 14, caractérisé en ce que le transistor (T) est un transistor MOS.

16. Dispositif photosensible selon l'une des revendications 8 à 15, caractérisé en ce que la diode de restauration (Dbz) présente un premier seuil de tension de mise en conduction dans le sens direct (Vs1), et un second seuil de tension pour la mise en conduction dans le sens inverse (Vs2).

17. Dispositif photosensible selon l'une des revendications précédentes, caractérisé en ce qu'il comporte en outre des moyens pour appliquer sur le conducteur en ligne (L1 à L3) :
- d'abord un niveau de tension de repos (VR) sur le conducteur en ligne (L1 à L3) pendant une phase d'exposition à la lumière ;
- puis au moins une impulsion de tension dite impulsion de lecture (IL) ayant un niveau (VL2) supérieur à un seuil de conduction (VT) du transistor (T) ;
- puis une impulsion de tension dite impulsion de restauration (IR) tendant à mettre à l'état "passant" le second dipôle (5) situé entre le point à potentiel flottant (A) et la tension d'alimentation (V_{DD}).

18. Dispositif photosensible selon la revendication 16, caractérisé en ce qu'il comporte en outre des moyens pour appliquer sur un conducteur en ligne (L1 à L3) :
- d'abord un niveau de tension de repos (VR) sur le conducteur de ligne pendant une phase d'exposition à la lumière ;
- puis au moins une impulsion de tension dite impulsion de lecture (IL) ayant une amplitude supérieure à un seuil de conduction (VT) du transistor (T) ;
- puis une impulsion de tension dite impulsion d'injection de charges (ICC) ayant un signe opposé à celui de l'impulsion de lecture (IL) ;
- enfin une impulsion de tension dite impulsion de remise à niveau (IRN) ayant un même signe que l'impulsion de lecture (IL), l'amplitude de l'impulsion de remise à niveau (IRN) étant sensiblement supérieure à l'écart entre la valeur du seuil de tension de mise en conduction directe (Vs1) et le seuil de mise en conduction en inverse (Vs2).

## Patentansprüche

1. Photoempfindliche Vorrichtung mit wenigstens einem Zeilenleiter (L1 bis L3), der wenigstens einen Spaltenleiter (F1 bis F3) kreuzt, einer photoempfindlichen Stelle (P1 bis P9), die im wesentlichen an einer jeweiligen Kreuzungsstelle zwischen einem Zeilenleiter (L1 bis L3) und einem Spaltenleiter (F1 bis F3) angeordnet ist, wobei die photoempfindliche Stelle (P1 bis P3) ein erstes und ein zweites Zweipolelement (4, 5) enthält, die in Reihe geschaltet sind und von denen wenigstens eines ein photoempfindliches Element ist, die Verbindungsstelle oder -zone der beiden Zweipole (4, 5) eine Stelle (A) mit schwebendem Potential bildet, wo elektrische Ladungen gespeichert werden, die erzeugt werden, indem die photoempfindliche Stelle dem Licht ausgesetzt wird, und wobei der erste Zweipol mit seinem zu der Stelle (A) mit schwebendem Potential entgegengesetzten Ende oder Pol mit einem Zeilenleiter (L1 bis L3) verbunden ist, dadurch gekennzeichnet, daß sie darüber hinaus ein Dreipolelement (T) vom Transistor-Typ enthält, von dem ein erster Pol (G) das Steuergitter bildet, daß das Steuergitter (D) mit der Stelle (A) mit schwebendem Potential verbunden ist, daß ein zweiter Pol (S) des Transistors (T) mit dem Spaltenleiter (F1 bis F3) verbunden ist, und daß der dritte Pol (Dr) des Transistors (T) zugleich einerseits mit einer Versorgungsspannung (V_{DD}) und andererseits mit dem zweiten Zweipol (5) über einen Pol oder ein Ende dieses zweiten Zweipols verbunden ist, der bzw. das zu der Stelle (A) mit schwebendem Potential entgegengesetzt ist.

2. Photoempfindliche Vorrichtung nach Anspruch 1, dadurch gekennzeichnet, daß das erste Zweipolelement (4) eine Diode (Da) ist.

3. Photoempfindliche Vorrichtung nach Anspruch 2, dadurch gekennzeichnet, daß die Diode (Da) aus amorphem Silizium besteht.

4. Photoempfindliche Vorrichtung nach Anspruch 1, dadurch gekennzeichnet, daß das erste Zweipolelement (4) ein Transistor (4) mit schwebender Basis ist.

5. Photoempfindliche Vorrichtung nach Anspruch 4, dadurch gekennzeichnet, daß der Transistor (4) mit schwebender Basis aus amorphem Silizium besteht.

6. Photoempfindliche Vorrichtung nach Anspruch 1, dadurch gekennzeichnet, daß der erste Zweipol (4) eine Isolationskapazität (Ci) ist.

7. Photoempfindliche Vorrichtung nach Anspruch 6, dadurch gekennzeichnet, daß das Dielektrikum der Isolationskapazität (Ci) aus einem photoleitenden Material vom Typ eines eigenleitenden amorphen Siliziums besteht.

8. Photoempfindliche Vorrichtung nach einem der vorhergehenden Ansprüche, dadurch gekennzeichnet, daß das zweite Zweipolelement (5) eine als Restaurationsdiode bezeichnete Diode (Db) ist.

9. Photoempfindliche Vorrichtung nach Anspruch 8, dadurch gekennzeichnet, daß die Restaurationsdiode (Db) aus amorphem Silizium besteht.

10. Photoempfindliche Vorrichtung nach Anspruch 1, dadurch gekennzeichnet, daß das erste und das zweite Zweipolelement (4, 5) durch Dioden (Da, Db) gebildet sind, die mit entgegengesetzten Durchlaßrichtungen miteinander in Reihe geschaltet sind.

11. Photoempfindliche Vorrichtung nach einem der vorhergehenden Ansprüche, dadurch gekennzeichnet, daß der Transistor (C) ausgehend von monokristallinem Silizium gebildet ist.

12. Photoempfindliche Vorrichtung nach Anspruch 11, dadurch gekennzeichnet, daß der Transistor (T) vom MOS-Typ ist.

13. Photoempfindliche Vorrichtung nach einem der Ansprüche 1 bis 10, dadurch gekennzeichnet, daß der Transistor (T) ausgehend von amorphem Silizium gebildet ist.

14. Photoempfindliche Vorrichtung nach Anspruch 13, dadurch gekennzeichnet, daß der Transistor (T) vom Typ eines Dünnschicht-Transistors ist.

15. Photoempfindliche Vorrichtung nach Anspruch 14, dadurch gekennzeichnet, daß der Transistor (T) ein MOS-Transistor ist.

16. Photoempfindliche Vorrichtung nach einem der Ansprüche 8 bis 15, dadurch gekennzeichnet, daß die Restaurationsdiode (Dbz) eine erste Schwellenspannung (Vs1) für ein Leiten in der Durchlaßrichtung und eine zweite Schwellenspannung (Vs2) für ein Leiten in der Sperrichtung aufweist.

17. Photoempfindliche Vorrichtung nach einem der vorhergehenden Ansprüche, dadurch gekennzeichnet, daß sie darüber hinaus Mittel enthält, um den Zeilenleiter (L1 bis L3) mit folgendem zu beaufschlagen:
- zunächst mit einem Ruhespannungspegel (VR), der an dem Zeilenleiter (L1 bis L3) während einer dem Licht ausgesetzten Phase anliegt,
- dann mit wenigstens einem als Leseimpuls (IL) bezeichneten Spannungsimpuls, dessen Pegel (VL2) über einer Leitschwelle (VT) des Transistors (T) liegt,
- dann einem als Restaurationsimpuls (IR) bezeichneten Spannungsimpuls, der dazu führt, daß der zwischen der Stelle (A) mit schwebendem Potential und der Versorgungsspannung (V_{DD}) liegende zweite Zweipol (5) in den "leitenden" Zustand versetzt wird.

18. Photoempfindliche Vorrichtung nach Anspruch 16, dadurch gekennzeichnet, daß sie darüber hinaus Mittel enthält, um einen Zeilenleiter (L1 bis L3) mit folgendem zu beaufschlagen:
- zunächst einem Ruhespannungspegel (VR), der an dem Zeilenleiter während einer dem Licht ausgesetzten Phase anliegt,
- dann wenigstens einem als Leseimpuls (IL) bezeichneten Spannungsimpuls, der eine Amplitude besitzt, die über einem Leitschwellwert (VT) des Transistors liegt,
- dann einem als Ladungsinjektionsimpuls (ICC) bezeichneten Spannungsimpuls mit einem Vorzeichen, das dem des Leseimpulses (IL) entgegengesetzt ist,
- und schließlich einem als Rücksetzimpuls bezeichneten Spannungsimpuls mit einem Pegel (IRN), der dasselbe Vorzeichen wie der Leseimpuls (IL) besitzt, wobei die Amplitude des Rücksetzimpulses mit dem Pegel (IRN) deutlich größer ist als der Abstand zwischen dem Wert der Schwellenspannung (Vs1) für ein Leiten in Durchlaßrichtung und dem Schwellwert (Vs2) für ein Leiten in Sperrichtung.

## Claims

1. A photosensitive device comprising at least one line conductor (L1 through L3) intersecting with at least one column conductor (F1 through F3), a photosensitive dot (P1 through P9) being arranged substantially at each intersection between a line conductor (L1 through L3) and a column conductor (F1 through F3), the photosensitive dot (P1 through P9) comprising a first and a second dipole element (4, 5) connected in series and of which at least one is photosensitive element, the dot or zone of connection of the two dipoles (4, 5) constituting a dot (A) with a floating potential where electrical charges are stored which are caused by exposure to light of the photosensitive dot, the first dipole (4) being connected with a line conductor (L1 through L3) by its end or pole opposite to the floating potential dot (A), characterized in that it comprises furthermore a tripole element (T) of the transistor type of which a first pole (G) constitutes the control gate, the control gate (G) being connected with a floating potential dot (A), a second pole (S) of the transistor (T) being connected with a column conductor (F1 through F3), the third pole (Dr) of the transistor (T) being connected simultaneously, on the one hand, with a supply voltage (V_{DD}), and on the other hand connected with the second dipole (5) by a pole or end of the same placed opposite to the floating potential point (A).

2. The photosensitive device as claimed in claim 1, characterized in that the first dipole element (4) is a diode (Da).

3. The photosensitive device as claimed in claim 2, characterized in that the diode (Da) is manufactured using amorphous silicon.

4. The photosensitive device as claimed in claim 1, characterized in that the first dipole element (4) is a floating base transistor (4).

5. The photosensitive device as claimed in claim 4, characterized in that the floating base transistor (4) is constituted by amorphous silicon.

6. The photosensitive device as claimed in claim 1, characterized in that the first dipole (4) is constituted by an isolating capacitor means (Ci).

7. The photosensitive device as claimed in claim 6, characterized in that the dielectric of the isolating capacitor means (Ci) is manufactured of a photoconductive material of the intrinsic amorphous silicon type.

8. The photosensitive device as claimed in any one of the preceding claims, characterized in that the second dipole element (5) is a restoring type diode (Db).

9. The photosensitive device as claimed in claim 8, characterized in that the restoring diode (Db) is manufactured using amorphous silicon.

10. The photosensitive device as claimed in claim 1, characterized in that the first and the second dipole elements (4, 5) are constituted by the diodes (Da, Db) connected in series back to back.

11. The photosensitive device as claimed in any one of the preceding claims, characterized in that the transistor (T) is constituted on the basis of monocrystalline silicon.

12. The photosensitive device as claimed in any one of the preceding claims, characterized in that the transistor (T) is of the MOS type.

13. The photosensitive device as claimed in any one of the claims 1 through 10, characterized in that the transistor (T) is constituted on the basis of amorphous silicon.

14. The photosensitive device as claimed in claim 13, characterized in that the transistor (T) is a thin film type transistor.

15. The photosensitive device as claimed in claim 14, characterized in that the transistor (T) is an MOS transistor.

16. The photosensitive device as claimed in any one of the claims 8 through 15, characterized in that the restoring diode (Dbz) has a first voltage threshold for causing it to conduct in the forward direction (Vₛ1) and a second voltage threshold for causing it to conduct in the reverse direction (Vₛ2).

17. The photosensitive device as claimed in any one of the preceding claims, characterized in that it furthermore comprises means for the application to the line conductor (L1 through L3) of:
- firstly a quiescent state voltage (VR) to the line conductors (L1 through L3) during a phase of exposure to light;
- then at least one read voltage pulse (IL) having a level (VL2) greater than a conduction threshold (VT) of the transistor (T);
- then a restoring voltage pulse (IR) tending to put the second dipole (5) in the "pass" condition, situated between the floating potential potential (A) and the supply voltage (V_{DD}).

18. The photosensitive device as claimed in claim 16, characterized in that it furthermore comprises means for the application to a line conductor (L1 through L3) of:
- firstly a quiescent state voltage (VR) to the line conductor during a phases of exposure to light;
- then at least one read voltage pulse (IL) having an amplitude greater than a conduction threshold (VT) of the transistor (T);
- then a charge injection voltage pulse (ICC) having a sign opposite to that of the read pulse (IL);
- and lastly a level restore voltage pulse (IRN) of the same sign as the read pulse (IL), the amplitude of the level restore pulse (IRN) being substantially greater than the difference between the value of the voltage threshold (Vs1) for causing forward conduction and the threshold (Vs2) for causing reverse conduction.
